# EUROPEAN PATENT APPLICATION

(11) **EP 2 717 313 A2**
(43) Date of publication of application: **09.04.2014**
(21) Application number: 12187818.5
(22) Date of filing: 09.10.2012
(51) Int. Cl.: H01L 25/075, H01L 51/52, H01L 27/32, H01L 33/20, H01L 33/24

(54) **Large area LED-lighting device**

(30) Priority: 08.10.2012 EP 12187642
(71) Applicant: Scheuten S.à.r.l., 5928 LL Venlo (NL); TNO innovation for life, 2628 VK Delft (NL)
(72) Inventor: Geyer, Volker, 52222 Stolberg (DE); Beckers, Edwin Hendrikus Anne, 6003 CA Weert (NL); Barink, Marco, 5683 NP Best (NL)
(74) Representative: Raasch, Detlef

(57) **Abstract**

The present invention concerns a large area LED-lighting device comprising a plurality of coated substrate beads coated with at least one light emitting layer, each forming an LED arrangement, whereby each coated substrate bead is at least partially embedded in a embedding layer and whereby each coated substrate bead is further at least contacted to one front and one back contact. The present invention further concerns a method for producing a corresponding large area LED-lighting device.

## Description

The present invention concerns a large area LED-lighting device comprising a plurality of coated substrate beads coated with at least one light emitting layer, each forming a LED arrangement, whereby each coated substrate bead is at least partially embedded in a embedding layer and whereby each coated substrate bead is further at least contacted to one front and one back contact. The present invention further concerns a method for producing a corresponding large area LED-lighting device.

Nowadays, light-emitting diodes (LEDs) play an increasingly important role in lighting applications because of their high light efficiency. Indeed, LEDs can for example emit more light (measured in lumen) per Watt compared to traditional incandescent light bulbs. Incandescent light bulbs may typically emit for example around 15 Im/W, whereas LEDs may typically emit for example about 30 to 80 Im/W, while even higher values may be reached. It has also to be noted that the light efficiency of LEDs is not affected by shape and size, unlike fluorescent light bulbs or tubes. Moreover, it should be noted that LEDs have a much higher lifetime compared to incandescent bulbs and fluorescent light bulbs or tubes. LEDs are also advantageously shock resistant, while incandescent bulbs and fluorescent light bulbs or tubes are quite fragile.

The advantages of LEDs thus make it a very desirable lighting source.

However, it is difficult to get efficient large area LEDs, since defects, which are detrimental to efficiency, are more likely once a large area is considered.

Furthermore, it has to be noted that efficient light extraction from LEDs still remains challenging.

Indeed, quantum efficiencies (photons generated per injected electron) can approach 100 %. However, at the best for example only 50 % of the photons generated will reach a transparent cover of the LED. The other photons are waveguided and/or absorbed in the LED stack. This is essentially due to the refractive index mismatch between the transparent cover and the light emitting layers of the LED.

Finally, for example only about 40 % of the photons reaching the transparent cover will escape into air because of the reflection at the air/substrate interface and/or because they are waveguided in the transparent cover.

This means that for example only 20 % of the photons produced are actually useful.

A better extraction of light would accordingly contribute to a better light efficiency. This would be especially desirable for efficient large area LED-lighting devices, where relatively high intensities may be desired.

The further fact that LEDs do not approximate a point source of light giving a spherical light distribution does thereby also not help to get efficient and homogeneous large scale lighting devices. Indeed, LEDs emit light only with given emission angle or viewing angle.

There is thus a need for an efficient and homogeneous large area LED-lighting device.

The present invention thus concerns a large area LED-lighting device comprising at least two coated substrate beads each individually coated with at least one light emitting layer, each forming a LED arrangement, whereby each coated substrate bead is at least partially embedded in a embedding layer and whereby each coated substrate bead is further at least contacted to one front and one back contact. The large area LED-lighting device according to the invention thus comprises at least two but preferably even more than two and thus multiple individual light emitting elements, namely substrate beads coated with at least one light emitting layer each forming an LED arrangement, scattered across a large surface area to achieve lighting in this area. A substrate bead could thereby for example have a nearly spherical, ovoid, ellipsoid or drop-like shape. Alternatively, a substrate bead could thereby for example be a sphere, an ovoid, an ellipsoid or a bead with a drop-like shape. A substrate bead can for example have a size/diameter comprised between 0,1 mm and 5 mm, preferably for example between 0,1 mm and 1 mm, further preferred between 0,1 mm and 0,5 mm. In some embodiments of the present invention, a part of the coated substrate beads and/or of the embedding layer can for example have been removed, so as to expose for example at least one part of at least one conductive layer arranged beneath the light emitting layer and/or at least one part of a conductive substrate bead. In the sense of the present invention, LEDs thereby comprise both encompasses LEDs based on inorganic semiconductor materials and OLEDs based on organic semiconductor materials. Each individual coated substrate bead coated with at least one light emitting layer can thereby for example emit light in any direction. The coated substrate beads coated with at least one light emitting layer can indeed advantageously for example emit light in any direction, because of their form. The light may especially for example be homogeneously emitted in any direction. The use of coated substrate beads coated with a light emitting layer, each forming an LED arrangement, can thereby for example improve the light efficiency and especially the light extraction for example by reducing wave guiding in a cover layer and especially a cover glass. This could allow to reduce the power necessary to achieve a given light output. Moreover, relying on individual coated substrate beads, each forming an LED arrangement, allows to get a very homogeneous lighting even for a large area LED-lighting device, since each coated substrate bead will emit light with a nearly spherical light distribution. It is thereby important to understand that each individual coated substrate bead is individually coated with at least one light emitting material. Beside of this, using multiple substrate beads at least partially protruding from a embedding layer with a given surface area may also increase active surface available to be coated by a light emitting layer compared to a flat substrate with the same given surface, so that the light output may be increased because the amount of active light emitting material present per surface unit can be increased accordingly. In addition, even in a large area lighting device the negative effect of defects can be reduced and actually limited to one sphere or even a part of a sphere, whereas a defect in a large area LED may have a negative influence on a much larger area. Neighboring beads coated with at least one light emitting layer can thereby for example take over from defective beads, especially given the fact that the beads coated with at least one light emitting layer emit light very homogeneously in any direction. This is further an advantage of using multiple individual light emitting elements to cover a large surface area and may allow to increase the dimensions of the large area LED-lighting device according to the present invention. The coated substrate beads may thereby for example cover between 5 % and more than 90 %, preferably between 10 % and 90,2 %, further preferred between 25 % and 90 %, further preferred between 50 % and 89 % of the surface area of the embedding layer of the large area LED-lighting device. A high density of spheres can for example be achieved using a hexagonal close packing and/or a cubic close packing arrangement of the coated substrate beads. Dimensions larger than for example 20 cm x 20 cm, 30 cm x 30 cm or even 30 cm x 1 m can easily be contemplated. Moreover, the large area LED-lighting device according to the present invention could for example be provided on a roll with a given width, so that the length may be relatively freely chosen by cutting a suitable piece of the rolled material. A large area LED-lighting device according to the present invention may thus for example be flexible. A large area LED-lighting device according to the present invention may thereby be a LED-lighting device with a large area intended to provide lighting by emitting light using LEDs.

The coated substrate beads may thereby be coated by at least one or more than one light emitting layer, so that each of them can for example form a LED arrangement. A light emitting layer may comprise at least one light emitting material. A light emitting material may thereby be any material which can emit electromagnetic radiation and preferably visible light, for example when a voltage and/or a current is applied. Light emitting materials can thereby comprise III-V-semiconductor compound, such as especially for example Gallium compounds, or organic conducting materials, such as for example poly(p(-phenylene vinylene)), polythiophen, polyfluorene, aluminium-tris(8-hydroxyquinoline), tris(2-phenylpyridine)- iridium (Ir(ppy)₃) and/or corresponding substituted materials and/or otherwise modified derivatives thereof as well as materials comprising the recited materials and/or corresponding substituted materials and/or otherwise modified derivatives thereof. Each coated substrate bead may thus for example form a LED and/or OLED arrangement. A LED and/or OLED arrangement may thereby for example be any element comprising a light emitting layer, which may emit light for example when a voltage and/or a current is applied to the layer. One light emitting layer may also for example comprise two or more layers of different materials forming one or more light emitting layer(s). The layers of different materials forming one light emitting layer may for example comprise one or more emissive layer(s) and/or one or more conductive layer(s) forming for example a LED and/or OLED arrangement.

Each individual coated substrate bead may thus optionally be coated by at least one electrically conductive layer beneath at least one light emitting layer and/or at least one electrically conductive layer above this light emitting layer(s) to form a LED arrangement. In the sense of the present invention, an electrically conductive layer can also be an semiconductive layer. The electrically conductive layer(s) arranged beneath at least one light emitting layer may for example be at least one metal and/or alloy layer, such as molybdenum, a silver, a gold and/or a copper layer and/or at least one layer of LiF, BaAl₄, calcium (Ca), barium (Ba), aluminum (Al), Mg₉Ag₁, Al:ZnO (aluminum doped ZnO), indium tin oxide, fluorine doped tin oxide layer doped zinc oxide, poly(3,4-ethylenedioxytiophene) (PEDOT), poly(4,4-dioctylcyclopentadithiophene), N,N'-diphenyl-N,N'-bis(3-methylphenyl)-1,1'-biphenyl-4,4-diamine (TPD), 4,4',4"-tris(N-carbazolyl)- triphenylamine (TCTA), 1,3,5-tris(N-phenylbenzimidazole-2-yl) benzene (TPBi), lithium doped bathophenanthroline (BPhen:Li) and/or of corresponding doped materials and/or of materials derived thereof. This/these conductive layer(s) can for example be used as hole injector (anode) and/or hole transporter layer(s) for the light emitting layer(s). Alternatively, this layer may not be necessary if the substrate bead is electrically conductive and especially metallic, so that the substrate bead as such can for example be used as hole injector (anode) and/or hole transporter layer(s). The electrically conductive layer(s) deposited above the light emitting layer(s) may preferably for example be a transparent layer of an electrically conductive material, such as for example a preferably transparent layer of molybdenum (Mo), silver (Ag), gold (Au), copper (Cu), LiF, BaAl₄, calcium (Ca), barium (Ba), aluminium (Al), Mg₉Ag₁, Al:ZnO (aluminum doped ZnO), indium tin oxide, fluorine doped tin oxide layer doped zinc oxide, poly(3,4-ethylenedioxytiophene) (PEDOT), poly(4,4-dioctylcyclopentadithiophene), N,N'-diphenyl-N,N'-bis(3-methylphenyl)-1,1'-biphenyl-4,4-diamine (TPD), 4,4',4"-tris(N-carbazolyl)- triphenylamine (TCTA), 1,3,5-tris(N-phenylbenzimidazole-2-yl) benzene (TPBi), lithium doped bathophenanthroline (BPhen:Li) and/or of corresponding doped materials and/or of materials derived thereof. This/these further layer(s) deposited above the light emitting layer(s) can be used for example as electron injector (cathode) and/or electron transport layer(s) for the light emitting layer(s). In addition, at least one further layer can optionally for example be provided as a barrier layer especially between the light emitting layer(s) and at least one electrically conductive layer(s) arranged adjacent to this layer(s) and/or between two adjacent electrically conductive layers arranged beneath or above the light emitting layer(s). Such a barrier layer can for example be any layer suitable hinder and/or reduce and/or avoid the diffusion of ions and/or compounds.. A barrier layer could for example be a ZnO layer, that could be provided optionally as a barrier for example between the light emitting layer and the electrically conductive layer arranged above this layer. Similarly, at least one other further interlayer can optionally be provided for example between the light emitting layer(s) and at least one electrically conductive layer arranged above or preferably beneath this layer and/or between two adjacent electrically conductive layers arranged above or preferably beneath the light emitting layer(s) for example to protect other layers and/or to better match the electronic states of the light emitting layer(s) and of the underlying electrically conductive layer(s). Such an interlayer may for example be at least one MoO₃, SiO₂, WO₃ or V₂O₅ layer provided for example between the light emitting layer(s) and at least one electrically conductive layer arranged beneath this layer and/or between two electrically conductive layers arranged above or beneath the light emitting layer(s) for example to protect other layers and/or to better match the electronic states of the light emitting layer and of the underlying electrically conductive layer. This could for example contribute to the fact that each individual coated substrate bead can form a LED arrangement.

The coated substrate beads coated with at least one light emitting layer, each forming an LED arrangement, may for example be arranged randomly or arranged with a regular pattern, such as for example arranged in lines, arranged according to a hexagonal close packing and/or a cubic close packing pattern. These arrangements can for example allow to achieve a very homogeneous lighting even or especially for larger areas. Moreover, the arrangement of the coated substrate beads coated with at least one light emitting layer, each forming an LED arrangement, can for example be different across the large area LED-lighting device and/or in at least two different areas of the large area LED-lighting device according to the present invention. The distance/spacing between coated substrate beads may therefore for example be varied across the large area LED-lighting device and/or in at least two different areas of the large area LED-lighting device according to the present invention. A random arrangement of the coated substrate beads allows for example to get a surface coverage by the coated substrate beads of approximately around 60 %, while achieving a very homogeneous lighting even or especially for larger areas. A random arrangement of the coated substrate beads could for example be obtained by merely randomly scattering coated substrate beads on/in a embedding layer and at least partially embedding the coated substrate beads in this embedding layer. A regular arrangement could provide more surface coverage by the coated substrate beads and thus more light emitting material as well as more light output per surface unit, while also achieving a very homogeneous lighting even and/or especially for larger areas. A regular arrangement of the coated substrate beads could for example be obtained by using an embedding layer comprising preformed depressions, grooves and/or holes/perforations arranged in a regular pattern, so that coated substrate beads can get placed in these depressions, grooves and/or holes to achieve a regular arrangement of the coated substrate beads. Alternatively, a regular arrangement of the coated substrate beads could also be achieved for example using a master/model plate with preformed depressions, grooves and/or holes/perforations arranged in a regular pattern, whereby this master/model plate could than subsequently be used to embed the coated substrate beads at least partially in the embedding layer, while keeping/achieving a regular pattern.

Coated substrate beads of an area of the large area LED-lighting device according to the present invention are preferably for example all connected in parallel. Different areas may for example be connected so that they may be lightened up, dimmed and/or shut off independently from one another. An area of the large area LED-lighting device according to the present invention could thereby for example be any part of the large area LED-lighting device comprising coated substrate beads coated with at least one light emitting layer, each forming an LED arrangement, that are all connected in parallel and/or any part of the large area LED-lighting device according to the present invention between two conductive members of the front contact and/or part of the large area LED-lighting device according to the present invention corresponding to an electrically conductive zone of the front or the back contact separated from another zone, so that there is not direct electrical contact between these zones. This can for example allow to electrically connect individual areas of the large area LED-lighting device according to the present invention, so that individual areas can for example be dimmed and/or even switched on or off individually, for example to achieve the dimming of the large area LED-lighting device according to the present invention or at least of parts of such a device.

Moreover, different individual areas of the large area LED-lighting device according to the present invention can for example comprise coated substrate beads coated with different light emitting materials, which can thus preferably for example emit light with different colors. This can for example allow to obtain and to mix/combine different light colors. This can further eventually also allow to obtain for example white light by combining different light colors.

A back contact may thereby for example be any electrically conductive arrangement located at one side of the large area LED-lighting device and thus of the embedding layer. On the other hand, a front contact may thereby for example be any electrically conductive arrangement located at the other opposite side (compared to the back contact) of the large area LED-lighting device and thus of the embedding layer. A front contact and/or a back contact can thereby for example especially comprise at least one electrically conductive layer, which may for example electrically contact at least two coated substrate beads and/or preferably all coated substrate beads of a large area LED-lighting device according to the present invention. At least one back contact and at least one the front contact thereby allow to apply a voltage and/or current to each coated substrate bead coated with at least one light emitting layer forming an LED, so as to allow the emission of light by the coated substrate beads. The front contact and the back contact could thereby especially for example be obtained by providing at least one continuous electrically conductive layer at either sides of the embedding layer, for example preferably so that the conductive layer(s) electrically contact the coated substrate beads at least partially embedded in the embedding layer.

In an embodiment of the large area LED-lighting device according to the present invention, the front contact and/or the back contact may for example comprise a transparent electrically conductive layer. Transparent can thereby mean completely transparent as well as also semi transparent and/or translucent. The front contact layer may thus for example comprise at least one TCO-layer and/or TCP-layer and/or a conductive transparent carbon nanotube based layer and/or at least one transparent BaAl₄, Ca, Ba, Al, Mg₉Ag₁ or Al:ZnO (aluminum doped ZnO) layer and/or at least one of these layers contacted to at least one conductive member. A TCO-layer may thereby for example comprise an indium-tin-oxide (ITO) layer, a fluorine doped tin oxide layer (FTO) or a doped zinc oxide layer, such as an aluminum-doped zinc-oxide layer (AZO) and/or other corresponding doped layer and/or layers of derived TCO materials. A TCP-layer may thereby for example comprise a poly(3,4-ethylenedioxytiophene) (PEDOT) layer, or a poly(4,4-dioctylcyclopentadithiophene) layer and/or corresponding doped layer and/or layers of derived TCP materials. Since the front contact can be for example a transparent layer, light emitted by the coated substrate beads coated with at least one light emitting layer, each forming an LED arrangement, may pass through the front contact. The front contact may thus be deposited on one side of the embedding layer and on top of the coated substrate beads coated with at least one light emitting layer, each forming an LED arrangement, which are at least partially embedded in the embedding layer and protrude from this layer, without notably decreasing the light output. The front contact and/or the back contact can thereby for example be a continuous conductive layer preferably electrically connected for example to all the coated substrate beads of the large area LED-lighting device according to the present invention.

One of the front or back contacts may thereby for example be a continuous electrically conductive layer, while the other one of the front and back contacts could for example comprise at least two different and separate electrically conductive zones, which are arranged so that there is no direct electrical contact between them. Alternatively, both of the front and the back contact could for example comprise at least two different and separate electrically conductive zones, which are arranged so that there is no direct electrical contact between them. The zones may thereby be obtained for example through patterning or by performing separation cuts through the conductive layers forming the front and back contacts.

In an embodiment of the large area LED-lighting device according to the present invention, at least one of the front and/or back contact(s) may for example comprise at least two different and separate electrically conductive zones, which are arranged so that there is no direct electrical contact between them. The zones may thereby be obtained for example through patterning or by performing separation cuts through the conductive layers forming the front and back contacts. This can for example allow to electrically connect individual zones of the large area LED-lighting device according to the present invention, so that individual areas can for example be dimmed and/or even switched on or off individually, for example to achieve the dimming of large area LED-lighting device according to the present invention or at least of parts of such a device. The front and/or the back contact may for example comprise a transparent conductive layer, such as for example a TCO-layer or a TCP-layer or a carbon nanotube based layer, so that this layer comprises at least two distinct separated zones, which are arranged so that there is no direct electrical contact between them. The front and/or back contact may be deposited as a conductive contact layer on the one or on each side of the embedding layer and on top of the coated substrate beads coated with at least one light emitting layer, each forming an LED arrangement, which are at least partially embedded in the embedding layer and protrude from this layer. Each coated substrate bead, on which the front and/or back contact is deposited, could actually be electrically contacted with this layer. If the front and/or back contact is deposited on the whole embedding layer and on all coated substrate beads at least partially embedded therein, they all get electrically contacted. To define zones of coated substrate beads, which are connected together and which may be dimmed and/or shut on or off together, the front and/or back contact may be cut to define at least two distinct areas separated by at least one separation cut. Alternatively, to cutting in the front and/or back contact, either the front and/or the back could be patterned by other techniques like for example deposition with screening/masking, photolithography, etching/scratching, printing and/or laser transfer. The distinct zones of the front and/or back contact are thereby for example not directly electrically connected one to another, since they are separated one from another by at least one cut. Distinct areas of the front and/or back contact may thereby for example comprise coated substrate beads coated with at least one light emitting layer, each forming an LED arrangement, which are connected together in parallel. This may for example allow whole areas the large area LED-lighting device according to the present invention to be dimmed and/or switched on or off individually, for example to achieve the dimming of the large area LED-lighting device according to the present invention.

Moreover, in one embodiment of the large area LED-lighting device, the front contact may comprise at least one conductive member, which may be for example a metal line and/or metal strip coating, such as for example a copper or silver strip shaped layer, deposited for example by PVD or CVD techniques, by photolithography, by printing, screening/masking or by laser transfer, and/or a metal band, such as for example a copper or silver band, or even a metal wire, such as for example a copper or silver wire. That the front contact comprises at least one conductive member may for example mean that the front contact can be electrically contacted to at least one conductive member. One or more than one conductive member(s) may thereby be preferably for example arranged between the coated substrate beads and/or embedded in the embedding layer. The conductive member(s) are thereby preferably arranged between the coated substrate beads coated with at least one light emitting layer, each forming an LED arrangement, to avoid shading the light emitted by the coated substrate beads coated with at least one light emitting layer, each forming an LED arrangement. In addition, in some embodiments of the large area LED-lighting device according to the present invention, the conductive members may be for example at least partially embedded in the embedding layer, especially for example when metal bands or wire are used. This allows to for example to fix the bands and/or wires easily to prevent them from wobbling around and eventually short-circuiting the large area LED-lighting device according to the present invention and thus allows larger dimensions. It may also for example provide more mechanical stability and resistance to the large area LED-lighting device according to the present invention. Embedding the conductive members at least partially in the embedding layer may also for example allow to reduce the thickness of the large area LED-lighting device according to the present invention, since at least a part of each conductive member gets buried into the embedding layer so that the thickness of the whole arrangement gets reduced. The conductive members may be embedded for example in a similar way to the coated substrate beads coated with at least one light emitting layer, each forming an LED arrangement, for example by using heat and/or pressure and/or by using a resin to form the embedding layer. The conductive members can for example be arranged vertically or horizontally, preferably for example parallel to each other and/or spaced apart from each other, so that the they are spaced apart from one another by between 1 mm and 10 cm, preferably 1,5 mm and 5 cm, further preferred between 2 mm and 2,5 cm, further preferred between 2,5 mm and 1 cm, further preferred between 3 mm and 7 mm. The conductive members can further for example be arranged over the whole surface of the large area LED-lighting device according to the invention. The use of a front contact comprising conductive members can thereby for example allows to achieve a very homogeneous current and/or voltage distribution, even in large area LED-lighting devices.

In an embodiment of the large area LED-lighting device according to the present invention, the front contact may comprise at least one TCO-layer contacted to at least one conductive member. The combination of at least one TCO-layer and at least one conductive member allows to conduct electrical current quickly and efficiently, since the higher electrical conductivity of the conductive members (compared to a TCO layer) improves the overall conductivity of the front contact. This allows to use less TCO (thinner layer) and may thus contribute to reduce the costs and to maximize the light output.

Furthermore, so called electrically conductive "via"-connections from the front contact of one zone/area to the back contact of another zone/area can for example be provided in one embodiment of the large area LED-lighting device according to the invention. A "via"-connection can thereby for example be provided by a conductive member which contacts the front contact of one area and the back contact of another distinct preferably adjacent area of the large area LED-lighting device. This can for example allow different areas of the large area LED-lighting device to be connected in series through "via"-connections

In an embodiment of the large area LED-lighting device according to the present invention, each coated substrate bead of a area may be contacted to one single front and to one single back contact, so that the coated substrate beads may preferably for example be connected in parallel and/or so that whole individual areas can for example be dimmed and/or even switched on or off individually, for example to achieve dimming of large area LED-lighting device according to the present invention.

The coated substrate beads coated with at least one light emitting layer, each forming an LED arrangement, may be at least partially embedded in the embedding layer. Partially embedded in the embedding layer may thereby for example mean that at least a part of each coated substrate bead lies within the embedding layer. The coated substrate beads may thereby for example at least partially protrude from the front side of the embedding layer and/or at least partially protrude from the back side of the embedding layer, while at least one part of the coated substrate beads actually lies within the embedding layer. The coated substrate beads may alternatively also be flush with the embedding layer, while at least one part of the coated substrate beads actually lies within the embedding layer. The coated substrate beads coated with at least one light emitting layer, each forming an LED arrangement, can for example protrude from the embedding layer, so that for example 5%, preferably 10 %, preferably 20 %, preferably 30 %, preferably 40 %, preferably 50 %, preferably 60 %, preferably 70 % of the volume of the coated substrate beads may protrude from the front side of the embedding layer. The coated substrate beads can thereby for example protrude more from one side of the embedding layer than from the other side of the embedding layer. Embedding the coated substrate beads at least partially in the embedding layer may be done for example by using heat and/or pressure to embed the coated substrate beads at least partially or by perforating the embedding layer, so that coated substrate beads placed in/on the perforations get at least partially embedded in the embedding layer. Alternatively, embedding the coated substrate beads at least partially in the embedding layer may be done for example by embedding the coated substrate beads at least partially in a resin, which can for example be cured to get an embedding layer. Curing can thereby for example be carried out by UV, temperature or e-beam curing methods.

The embedding layer may for example comprise at least one polymer layer, preferably a flexible polymer layer and/or a transparent polymer layer, and especially for example a thermoplastic polymer layer. A polymer layer can thereby preferably for example be an acrylic and/or methacrylic polymer layer, an epoxide layer, a polyester layer, a polycarbonate layer, a polyimide and/or a polyurethane layer. A polymer layer may thereby have a good mechanical resistance, while it can moreover advantageously be transparent. The good mechanical resistance and stability of a polymer layer can thereby for example allow to impart a sufficient mechanical resistance and stability to the large area LED-lighting device according to the present invention, so that large dimensions may be contemplated. Using a transparent polymer material as a embedding layer may for example allow to improve the light output of the coated substrate beads, which are at least partially embedded in the embedding layer, since even for example the light emitted by the parts of the coated substrate beads embedded in the embedding layer and/or the light emitted by the parts of the coated substrate beads protruding and/or located at the back side of the embedding layer can shine through the transparent embedding layer to possibly improve the light output. Beside of this, using a polymer layer as embedding layer may also for example allow to embed the coated substrate beads easily at least partially in the embedding layer. This may be done for example by subjecting the polymer layer used as embedding layer to heat, so as to soften it, and/or by pressing the coated substrate beads into it by relying on sufficient pressure, so that at least a part of each coated substrate bead gets embedded in the embedding layer. Moreover, the polymer layer used as embedding layer may be pre-perforated before the coated substrate beads get at least partially embedded, so that due to the perforations it is not necessary to press the coated substrate beads into to polymer layer used as embedding layer to get them at least partially embedded into it, when the coated substrate beads get placed in or on perforations, or so that pressing the coated substrate beads into the polymer layer used as embedding layer becomes easier, when the coated substrate beads get placed in or on perforations. The embedding layer may also for example be formed using a resin, such as for example an acrylic and/or methacrylic and/or a urethane and/or an ester and/or an imide and/or an epoxide monomer or polymer/oligomer resin, which can for example be cured to embed the coated substrate beads at least partially and to obtain a preferably for example transparent embedding layer. Alternatively, the embedding layer may also comprise a metal layer or it may alternatively even be a metal foil or preferably a perforated metal foil. The metal foil, which may be used as embedding layer, may moreover for example comprise parabolic grooves. In some embodiments the metal foil, which may be used as embedding layer, may for example comprise parabolic grooves, which could for example surround perforations. In this case, at least one additional transparent polymer layer may be arranged on one or on both sides of the metal foil used as embedding layer, as additional part(s) of this layer. Such an arrangement with an additional polymer layer may for example help to fix the coated substrate beads and to keep them in place, when a metal foil is used as embedding layer. The coated substrate beads can therefore preferably for example also be at least partially embedded in this/these polymer layer(s). Using an embedding layer comprising a metal layer or using a metal foil as an embedding layer may thereby for example reflect light which is scattered back and thus increase the light output. A rough metal layer or metal foil used as embedding layer may thereby for example be used to increase the amount of diffuse light emitted by the large area LED-lighting device according, so as to achieve a more diffuse lighting. A rough metal layer may thereby for example be obtained by roughening a polymer embedding layer and depositing a metal layer on the rough surface of such a rough layer. A smooth metal layer or metal foil would on the other hand for example achieve a more specular reflection of the emitted light. Parabolic grooves may thereby for example serve to achieve directed lighting, as the grooves may direct the emitted light.

The substrate beads coated by at least one light emitting layer, each forming an LED arrangement, may for example be glass, polymer, metal, such as for example iron or molybdenum, alloy or metallic oxide beads. The substrate beads are however preferably for example not semiconductor beads. Instead a light emitting layer is rather deposited on the substrate beads, this allows to keep a lot of flexibility regarding the light emitting layer. The substrate beads used in the large area LED-lighting device according to the present invention can all be coated with the same light emitting material(s) or with different light emitting materials. This may for example allow to obtain and/or to mix/combine different light colors. This may further also eventually for example allow to obtain white light by doing so. The substrate beads may moreover for example comprise a magnetic material to eventually facilitate their arrangement and placement. The substrate beads coated by at least one light emitting layer, each forming an LED arrangement, may for example have a diameter comprised between 5 µm and 2000 µm, preferably between 7,5 µm and 1000 µm, preferably between 10 µm and 500 µm, preferably between 50 µm and 400 µm, preferably between 100 µm and 300 µm, preferably between 150 µm and 250 µm, even more preferred between 175 µm and 225 µm. Bigger coated substrate beads could thereby for example facilitate their arrangement, placement and/or manipulation. Smaller coated substrate beads may for example allow to achieve a higher flexibility, when obtaining a flexible the large area LED-lighting device according to the present invention is contemplated.

In an embodiment of the large area LED-lighting device according to the present invention, the back contact may comprise at least one smooth or rough metal layer. A rough metal layer may for example be a structured metal layer used to achieve a given roughness. Alternatively, a rough metal layer may eventually also be provided as an additional layer in addition to a back contact layer. The rough metal layer may thereby for example reflect a part of the light, while the roughness would increase the amount of diffuse light emitted by the large area LED-lighting device according, so as to achieve a more diffuse lighting. A smooth metal layer would on the other hand for example achieve a more specular reflection of the emitted light.

In an embodiment of the large area LED-lighting device according to the present invention, the large area LED-lighting device can comprise for example at least one additional rough polymer layer on the back. The rough polymer layer can for example increase the amount of diffuse light emitted by the large area LED-lighting device according to the present so as to achieve a more diffuse lighting.

In an embodiment of the large area LED-lighting device according to the present invention, can further comprise at least one protective layer, such a layer could for example be a protective cover layer and/or a water barrier layer and/or a water vapor barrier layer and/or an oxygen barrier layer and/or an air barrier layer. A protective layer can for example be added on each side of the large area LED-lighting device according to the present invention. A protective cover layer and/or a water barrier layer and/or a water vapor barrier layer and/or an oxygen barrier layer and/or an air barrier layer can thereby for example comprise at least one polymer layer, such as for example a PET-layer and/or an inorganic layer, such as for example an aluminum foil and/or an oxide based layer, and/or a glass sheet and/or combinations of at least two layers selected for example among the layer mentioned here before. A protective layer can thus protect the large area LED-lighting device according to the present invention from external influences and damages. Polymer protective layers may thereby for example contribute to make the device flexible. A protective cover layer may thereby for example provide mechanical stability and/or protection against physical damages. On the other hand, a barrier layer may serve for example as a barrier against external influences.

In an embodiment of the method for producing a large area LED-lighting device according to the present invention, the large area LED-lighting device may comprise a cover layer comprising at least one fluorescent dye, which may emit white light once irradiated by the light produced by the light emitting layer of the coated substrate beads. This may for example help to produce white light.

The present invention further relates to a method for producing a large area LED-lighting device according to the present invention, whereby the method comprises the following steps:
- coating substrate beads with at least one light emitting layer to form a LED arrangement,
- embedding the coated substrate beads at least partially in at least one a embedding layer
- coating the partially embedded coated substrate beads with a transparent conductive layer deposited on one side of the embedding layer, as a front contact,
- further coating the other side of the embedding layer and the partially embedded coated substrate beads with at least one other conductive layer deposited on the other side of the embedding layer.

In an embodiment, the method may further comprise for example at least one step of coating substrate beads with at least one electrically conductive layer. Such a step may be carried out for example before and/or after a step of coating the substrate beads with at least one light emitting layer. The coated substrate beads may thus for example comprise at least one electrically conductive layer arranged beneath and/or above the light emitting layer.

The coating steps may be carried out using any suitable coating method and especially for example using any suitable PVD, CVD or casting method and/or by printing.

At least partially embedding the coated substrate beads coated with at least one light emitting layer, each forming an LED arrangement, in the embedding layer may be done for example by using heat, for example to soften the embedding layer, and/or pressure to press the coated substrate beads into the embedding layer to embed the coated substrate beads at least partially in the embedding layer. Alternatively or additionally, a perforation step may be performed to perforate the embedding layer, so that coated substrate beads can for example be placed in/on the perforations get at least partially embedded in the embedding layer either easier using the method described above or even without further processing, just by simple placement on or in the perforations. This may also for example contribute to arranging the coated substrate beads. If the embedding layer is formed using a resin, the coated substrate beads may for example be incorporated in a thin resin layer before curing the resin to embed the coated substrate beads at least partially in the embedding layer.

In an embodiment of the method for producing a large area LED-lighting device according to the present invention, the method can further for example comprise a step of at least partially embedding at least one conductive member, especially for example a metal band or metal wire, in the embedding layer. Embedding at least one conductive member, especially for example a metal band or a metal wire, at least partially in the embedding layer may be done for example by using heat, for example to soften the embedding layer, and/or pressure to press a conductive member, especially for example a metal band or a metal wire, to embed them at least partially in the embedding layer. If the embedding layer is formed using a resin, at least one conductive member may for example be incorporated in a thin resin layer before curing the resin to embed the conductive member(s) at least partially in the embedding layer. Alternatively, at least one conductive member may be applied as metal strip coating, such as for example a copper or silver strip shaped layer, deposited for example by PVD or CVD techniques and/or by using conductive inks, such as for example silver, nickel or carbon containing conductive inks, and/or by printing techniques, such as for example screen printing, laser transfer printing or the like, on the embedding layer and especially on the front side of the embedding layer. This step of embedding and/or applying one conductive member could for example be performed before the step of coating the partially embedded coated substrate beads with a transparent conductive layer deposited on one side of the embedding layer, as a front contact. This may for example improve the conductivity of the front contact, when the front contact comprises at least one conductive member and/or is electrically connected to at least one conductive member.

In an embodiment of the method for producing a large area LED-lighting device according to the present invention, the method can further for example comprise a step of cutting through and/or patterning the front contact and/the back contact to get at least two distinct zones, which are not electrically connected. The cutting step may thereby especially for example be carried out by laser cutting. The patterning of the front contact and/or the back contact can be carried out by an additional patterning step, especially for example a deposition step with screening/masking, by a patterning photolithography step, by a patterning etching/scratching step, by a patterning printing step and/or a patterning laser transfer step. This may for example allow whole zones of the large area LED-lighting device according to the present invention to be dimmed and/or switched on or off together, for example to achieve the dimming of the large area LED-lighting device according to the present invention.

In an embodiment of the method for producing a large area LED-lighting device according to the present invention, the method can further for example comprise a step of removing at least a part of the coated substrate beads, especially prefered of the coating(s) of the coated substrate beads, and/or of the embedding layer, so as to expose at least one part of a conductive layer of the coated substrate bead arranged beneath the light emitting layer and/or a part of a conductive substrate bead. at least a part of the coated substrate beads, especially preferred of the coating(s) of the coated substrate beads, and/or of the embedding layer, can thereby be removed for example by abrasion, polishing, etching, application of energy for example using a laser or radiation and/or by a photolithographic process. This may for example allow that a/the conductive layer deposited on the embedding layer on the side where a part of the coated substrate beads and/or of the embedding layer has been removed may preferably for example contact at least a part of an exposed conductive layer arranged beneath the light emitting layer of a/the coated substrate bead(s) and/or of a/the conductive substrate bead(s).

In an embodiment of the method for producing a large area LED-lighting device according to the present invention, the method can further for example comprise a step of adding at least one additional protective layer and/or a metal layer or metal foil on one or on both sides of the embedding layer. An additional protective layer added on the front side of the embedding layer may for example allow to protect the coated substrate beads coated with at least one light emitting layer, each forming an LED arrangement, and the embedding layer and the coated substrate beads. An additional metal layer or metal foil added on the back side of the embedding layer may also for example allow to protect the embedding layer. An additional metal layer or metal foil may moreover for example reflect at least a part of the emitted light to increase the light output. A rough metal layer/foil and/or a rough polymer protective layer may furthermore increase the amount of diffused light emitted.

The different layers of a large area LED-lighting device according to the present invention may further for example be assembled, especially for example by laminating them and/or gluing them together and/or for example by applying pressure and/or heat in an additionnal step.

In an embodiment of the method for producing a large area LED-lighting device according to the present invention, the large area LED-lighting device may comprise for example at least one cover layer comprising at least one fluorescent dye, which may emit white light once irradiated by the light produced by the light emitting layer of the coated substrate beads. This may for example help to produce white light.

In an embodiment of the method for producing a large area LED-lighting device according to the present invention, the method can further for example comprise a step of using and/or adding and/or removing an additional temporary carrier layer. This temporary carrier layer can be added to the embedding layer before and/or after the conductive layers are applied thereon to provide further mechanical stability and can for example be removed once further layers and especially at least one protective layer are added.

Further additional layers and/or coatings with specific properties may thereby also for example be added either during the manufacturing or even afterwards.

A large area LED-lighting device according to the present invention can for example comprise substrate beads coated with the following layers:
Substrate bead/Mo/MoO₃, polyfluorene, ZnO, Al:ZnO
   or
Substrate bead/ITO/WO₃/TCTA/TPBi:Ir(ppy)₃/TPBi/BPhen:Li/ITO

Each individual substrate bead can thus for example be coated by an electrically conductive molybdenum layer, used as a hole injector (anode), arranged beneath at least one light emitting polyfluorene layer and by at least an electrically conductive layer aluminum doped ZnO (Al:ZnO), used a an electron injector (cathode), deposited above this light emitting layer to form a LED arrangement. Moreover, a further ZnO layer, is provided as a barrier between the light emitting layer and the electrically conductive layer arranged above this layer. Similarly, another further MoO₃ layer may be provided between the light emitting layer and the electrically conductive layer arranged beneath this layer for example to better match the electronic states of the light emitting layer and of the underlying electrically conductive layer. This arrangement contributes to the fact that each individual coated substrate bead can form a LED arrangement.

Alternatively, each individual substrate bead can for example be coated by an electrically conductive ITO layer, used as a hole injector (anode), arranged beneath at least one light emitting TPBi:Ir(ppy)₃layer, which is a TPBi layer doped with Ir(ppy)₃ and thus comprising Ir(ppy)₃, and further coated by at least an electrically conductive ITO layer, used a an electron injector (cathode), deposited above the light emitting layer to form a LED arrangement.. A TCTA layer is arranged beneath the light emitting layer as a hole transport layer. Moreover, a further WO₃ layer may be provided as an interlayer between the light emitting layer and the electrically conductive layer arranged beneath this layer and especially for example between the ITO layer and the TCTA layer arranged beneath the light emitting layer for example to better match the electronic states of the light emitting layer and of the underlying electrically conductive TPBi and BPhen:Li layers are deposited above the light emitting layer as electron transport layers. This arrangement contributes to the fact that each individual coated substrate bead can form a LED arrangement. As such an arrangement can furthermore be advantageously be transparent, it can moreover also for example contribute to increase the efficiency of the large area LED-lighting device according to the present invention.

The thickness of the individual layers can thereby for example preferably be between 1 nm and 500 nm, further preferred between 1 nm and 250 nm, further preferred between 1 nm and 200 nm, further preferred between 1 nm and 150 nm, further preferred between 1 nm and 100 nm, further preferred between 1 nm and 10 nm, further preferred between 50 nm and 200 nm, further preferred between 50 nm and 150 nm, further preferred between 75 nm and 150 nm. The thickness may be chosen depending on requirements of the lighting device according to the present invention.

Description of the drawings:

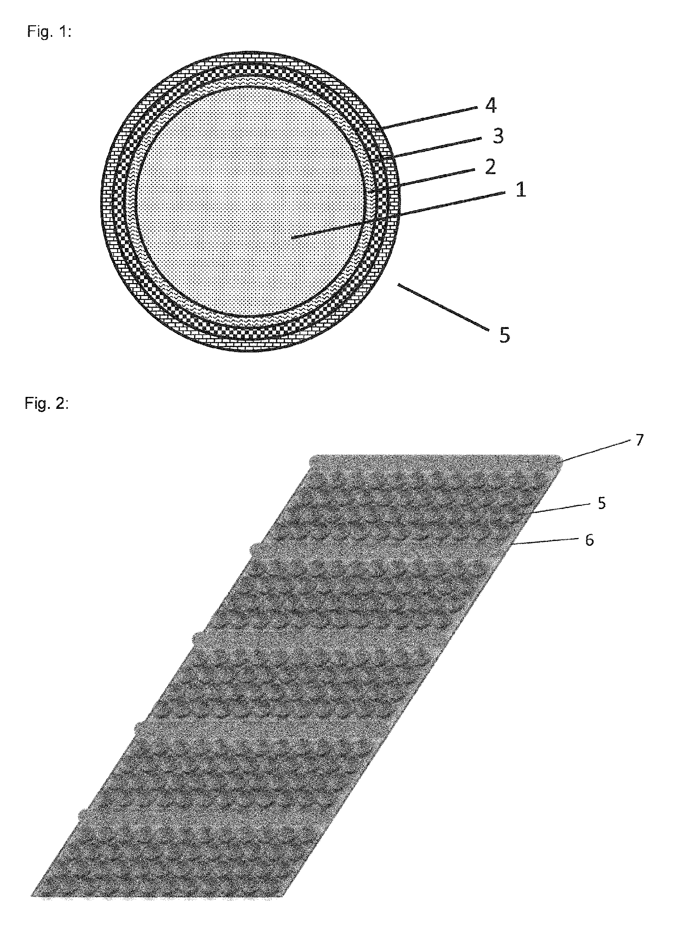

Fig. 1 shows an example of a coated substrate bead (5) coated with at least one light emitting layer (3) comprising a substrate bead (1) coated with a by an electrically conductive layer (2), used as a hole injector (anode), arranged beneath at least one light emitting layer (3) and by at least an electrically conductive layer (4), used as a an electron injector (cathode), deposited above the light emitting layer.
Fig. 2 shows an isometric top view of an example of a large area LED-lighting device according to the present invention comprising coated substrate beads. It comprises multiple coated substrate beads (5) each individually coated with at least one light emitting layer, each forming a LED arrangement, whereby each coated substrate bead is at least partially embedded in an embedding layer (6). The large area LED-lighting device comprises a front contact with conductive copper wires as conductive members (7), which are also partially embedded in the embedding layer. The conductive members are thereby arranged between the coated substrate beads (5), horizontally, parallel and spaced apart from each other.

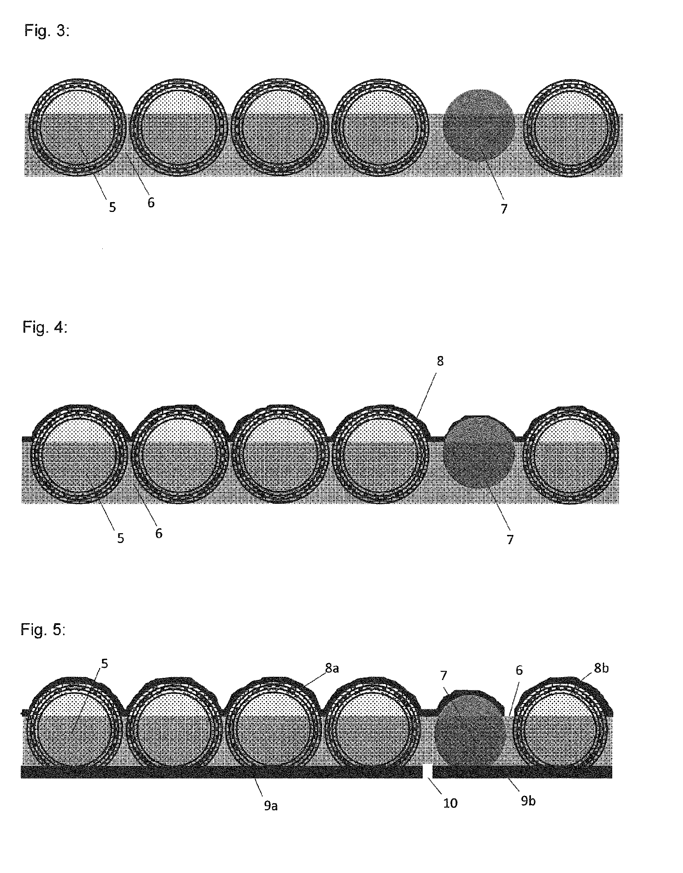

Fig. 3 shows a cross-section view (across the conductive members (7)) of coated substrate beads (5) each individually coated with at least one light emitting layer, each forming a LED arrangement, and conductive members each at least partially embedded in an embedding layer (6). The cross section in this view is perpendicular to the conductive copper wires as conductive members (7), so that a cross-section through these members is also shown. The arrangement shown is obtained by coating substrate beads with at least one first conductive layer, arranged beneath the light emitting layer, with at least one light emitting layer to form a LED arrangement and with at least one further conductive layer, arranged above the light emitting layer, by embedding the coated substrate beads (5) at least partially in an embedding layer (6) and by also embedding the conductive members (7) at least partially in the embedding layer. The conductive front contact is not yet deposited and thus not yet shown.
Fig. 4 shows a cross-section view (across the conductive members (7), same view as above) of coated substrate beads (5) each individually coated with at least one light emitting layer, each forming a LED arrangement, whereby each coated substrate bead is at least partially embedded in an embedding layer (6). A transparent TCO-front contact (8) deposited on one side of the embedding layer (6) thereby comprises conductive copper wires as conductive members (7), so that the front contact electrically contacts the conductive members (7).
Fig. 5 shows a cross-section view (across the conductive members (7), same view as above) of an example of a large area LED-lighting device according to the present invention comprising coated substrate beads (5) each individually coated with at least one light emitting layer, each forming a LED arrangement, whereby each coated substrate bead is at least partially embedded in an embedding layer (6). A transparent TCO-front contact (8) deposited on one side of the embedding layer (6) thereby comprises copper wires as conductive members (7). A part of the coated substrate beads and/or of the embedding layer has been removed, so as to expose at least one part of at least one conductive layer arranged beneath the light emitting layer of the coated substrate beads and/or at least one part of a conductive substrate beads. A conductive layer is then applied on the other side of the embedding layer (6) to serve as back contact (9), so that this layer preferably electrically contacts at least one part of a conductive layer arranged beneath the light emitting layer and/or at least one conductive substrate bead. The front contact (8) and the back contact (9) both comprise separation cuts (10) to define distinct zones/areas of the front contact (8a, 8b), which are not directly electrically connected, as well as distinct zones/areas of the back contact (9a, 9b), which are again not directly electrically connected. The conductive member (7) is used as "via"-connection to connect the front contact of one area (8a) to the back contact of another area (9b), so that areas of the large area lightning device according to the invention are connected in series.

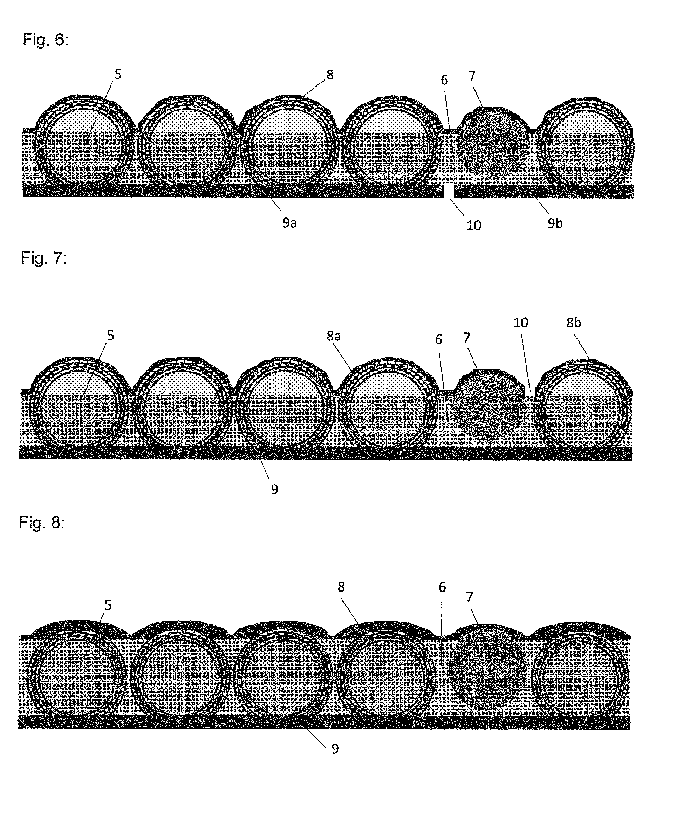

Fig. 6 shows a cross-section view (across the conductive members (7), same view as above) of an example of a large area LED-lighting device according to the present invention comprising coated substrate beads (5) each individually coated with at least one light emitting layer, each forming a LED arrangement, whereby each coated substrate bead is at least partially embedded in an embedding layer (6). A transparent TCO-front contact (8) deposited on one side of the embedding layer (6) thereby comprises copper wires as conductive members (7). A part of the coated substrate beads and/or of the embedding layer has been removed, so as to expose at least one part of a conductive layer arranged beneath the light emitting layer of the coated substrate beads and/or of a conductive substrate beads. A conductive layer is then applied on the other side of the embedding layer (6) to serve as back contact (9), so that this layer preferably electrically contacts at least one part of a the conductive layer arranged beneath the light emitting layer and/or a conductive substrate bead. The back contact (9) comprises separation cuts (10) to define distinct zones/areas of the back contact (9a, 9b), which are not directly electrically connected. Each area of the large area LED-lighting device according to the present invention corresponding to the zones of the back contact (9a, 9b) can be dimmed and/or turned on or off individually.
Fig. 7 shows a cross-section view (across the conductive members (7), same view as above) of an example of an alternative embodiment of a large area LED-lighting device according to the present invention comprising coated substrate beads (5) each individually coated with at least one light emitting layer, each forming a LED arrangement, whereby each coated substrate bead is at least partially embedded in an embedding layer (6). A transparent TCO-front contact (8) deposited on one side of the embedding layer (6) thereby comprises copper wires as conductive members (7). A part of the coated substrate beads and/or of the embedding layer has been removed, so as to expose at least one part of at least one conductive layer arranged beneath the light emitting layer of the coated substrate beads and/or at least one part of a conductive substrate beads. A conductive layer is then applied on the other side of the embedding layer (6) to serve as back contact (9), so that this layer preferably electrically contacts at least one part of a conductive layer arranged beneath the light emitting layer and/or at least one conductive substrate bead. The front contact (9) comprises separation cuts (10) to define distinct zones of the front contact (9a, 9b), which are not directly electrically connected. Each area of the large area LED-lighting device according to the present invention corresponding to the zones of the front contact (9a, 9b) can thereby be dimmed and/or turned on or off individually.
Fig. 8 shows a cross-section view (across the conductive members (7), same view as above) of a further example of an alternative embodiment of a large area LED-lighting device according to the present invention comprising coated substrate beads (5) each individually coated with at least one light emitting layer, each forming a LED arrangement, whereby each coated substrate bead is at least partially embedded in an embedding layer (6). A transparent TCO-front contact (8) deposited on one side of the embedding layer (6) thereby comprises copper wires as conductive members (7). A part of the coated substrate beads and/or of the embedding layer has been removed, so as to expose at least one part of at least one conductive layer arranged beneath the light emitting layer of the coated substrate beads and/or at least one part of a conductive substrate beads. A conductive layer is then applied on the other side of the embedding layer (6) to serve as back contact (9), so that this layer preferably electrically contacts at least one part of a conductive layer arranged beneath the light emitting layer and/or at least one conductive substrate bead. The coated substrate beads (5) are thereby nearly completely embedded in the embedding layer (6). Less than 10 % of the volume of the coated substrate beads (5) can for example be protruding from the embedding layer (6).

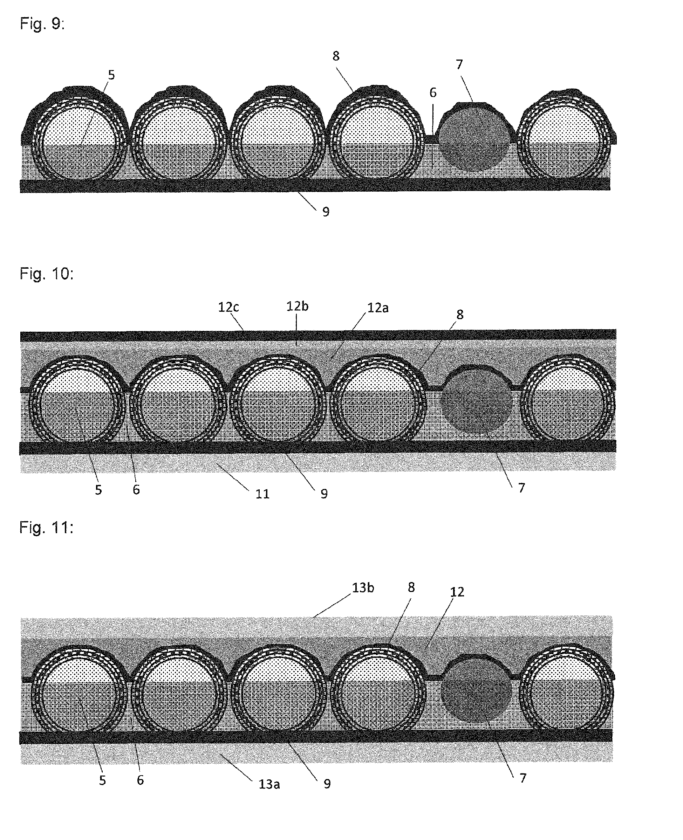

Fig. 9 shows a cross-section view (across the conductive members (7), same view as above) of a further example of an alternative embodiment of a large area LED-lighting device according to the present invention comprising coated substrate beads (5) each individually coated with at least one light emitting layer, each forming a LED arrangement, whereby each coated substrate bead is at least partially embedded in an embedding layer (6). A transparent TCO-front contact (8) deposited on one side of the embedding layer (6) thereby comprises copper wires as conductive members (7). A part of the coated substrate beads and/or of the embedding layer has been removed, so as to expose at least one part of at least one conductive layer arranged beneath the light emitting layer of the coated substrate beads and/or at least one part of a conductive substrate beads. A conductive layer is then applied on the other side of the embedding layer (6) to serve as back contact (9), so that this layer preferably electrically contacts at least one part of a conductive layer arranged beneath the light emitting layer and/or at least one conductive substrate bead. The coated substrate beads (5) are thereby only very partially embedded in the embedding layer (6). Around 50 % of the volume of the coated substrate beads (5) can for example be protruding from the embedding layer (6).
Fig. 10 shows a cross-section view (across the conductive members (7), same view as above) of a further example of an alternative embodiment of a large area LED-lighting device according to the present invention comprising coated substrate beads (5) each individually coated with at least one light emitting layer, each forming a LED arrangement, whereby each coated substrate bead is at least partially embedded in an embedding layer (6). A transparent TCO-front contact (8) deposited on one side of the embedding layer (6) thereby comprises copper wires as conductive members (7). A part of the coated substrate beads and/or of the embedding layer has been removed, so as to expose at least one part of at least one conductive layer arranged beneath the light emitting layer of the coated substrate beads and/or at least one part of a conductive substrate beads. A conductive layer is then applied on the other side of the embedding layer (6) to serve as back contact (9), so that this layer preferably electrically contacts at least one part of a conductive layer arranged beneath the light emitting layer and/or at least one conductive substrate bead. The large area LED-lighting device according to the present invention further comprises a protective layer (11) arranged on one side of the embedding layer and above the back contact as well as three protective layers (12a, 12b, 12c) arranged on the other side of the embedding layer, on top of the front contact. The protective layer (11) can thereby for example be a protective polymer cover layer and/or a polymer water barrier layer and/or a polymer water vapor barrier layer and/or a polymer air barrier layer and/or a polymer oxygen barrier layer. The protective layers (12a, 12b, 12c) can on the other hand comprise a polymer water barrier layer and/or a polymer water vapor barrier layer and/or a polymer air barrier layer and/or a polymer oxygen barrier layer (12a), an inorganic barrier layer (12b), such as for example an oxide based water barrier layer and/or an oxide based water vapor barrier layer and/or an oxide based air barrier layer and/or an oxide based oxygen barrier layer (12b) and a protective polymer cover layer (12c). The arrangement shown is thereby preferably flexible.
Fig. 11 shows a cross-section view (across the conductive members (7), same view as above) of a further example of an alternative embodiment of a large area LED-lighting device according to the present invention comprising coated substrate beads (5) each individually coated with at least one light emitting layer, each forming a LED arrangement, whereby each coated substrate bead is at least partially embedded in an embedding layer (6). A transparent TCO-front contact (8) deposited on one side of the embedding layer (6) thereby comprises copper wires as conductive members (7). A part of the coated substrate beads and/or of the embedding layer has been removed, so as to expose at least one part of at least one conductive layer arranged beneath the light emitting layer of the coated substrate beads and/or at least one part of a conductive substrate beads. A conductive layer is then applied on the other side of the embedding layer (6) to serve as back contact (9), so that this layer preferably electrically contacts at least one part of a conductive layer arranged beneath the light emitting layer and/or at least one conductive substrate bead. The large area LED-lighting device according to the present invention further comprises a protective layer (13a) arranged on one side of the embedding layer and above the back contact as well as two protective layers (12, 13b) arranged on the other side of the embedding layer. The protective layer (13a) can thereby for example be a glass sheet, arranged on one side of the embedding layer on top of the back contact. The protective layers (12 and 13b) can on the other hand comprise a polymer water barrier layer and/or a polymer water vapor barrier layer and/or a polymer air barrier layer and/or a polymer oxygen barrier layer (12) and a glass sheet (13b), arranged on the other side of the embedding layer on top of the front contact. The glass sheet (13b) is thereby arranged on top of the protective polymer layer (12).

## Claims

1. Large area LED-lighting device,
**characterized in that**,
it comprises at least two coated substrate beads each individually coated with at least one light emitting layer, each forming an LED arrangement, whereby each coated substrate bead is at least partially embedded in an embedding layer and whereby each coated substrate bead is at least contacted to one front and one back contact.

2. Large area LED-lighting device according to claim 1,
**characterized in that**,
the coated substrate beads are arranged randomly or with a regular pattern.

3. Large area LED-lighting device according to any of the preceding claims,
**characterized in that**,
each coated substrate bead of an area is contacted to a single front contact and to a single back contact.

4. Large area LED-lighting device according to of the claims 1 or 2,
**characterized in that**,
the embedding layer is a metal foil or a polymer layer, especially a transparent polymer layer, especially an acrylic and/or methacrylic polymer layer, an epoxide layer, a polyester layer, a polycarbonate layer, a polyimide and/or a polyurethane layer.

5. Large area LED-lighting device according to any of the preceding claims,
**characterized in that**,
the coated substrate beads are substrate beads with a diameter comprised between 5 µm and 2000 µm.

6. Large area LED-lighting device according to any of the preceding claims,
**characterized in that**,
the front contact comprises at least one transparent conductive layer and/or at least one transparent conductive layer comprising at least one conductive member and/or contacted to at least one conductive member.

7. Large area LED-lighting device according to claim 6,
**characterized in that**,
that one or more conductive member(s) are arranged between the coated substrate beads and/or embedded in the embedding layer.

8. Large area LED-lighting device according to one of the claims 6 or 7,
**characterized in that**,
the front contact and/or the back contact comprise(s) at least two distinct zones, without direct electrical contact.

9. Large area LED-lighting device according to any of the preceding claims,
**characterized in that**,
the back contact comprises at least one first metal layer and/or a least another different second metal layer.

10. Large area LED-lighting device according to any of the preceding claims,
**characterized in that**,
the back contact comprises at least one rough metal layer.

11. Large area LED-lighting device according to any of the preceding claims,
**characterized in that,**
the large area LED-lighting device comprises an additional rough polymer layer a on its back side.

12. Method for producing a large area LED-lighting device according to one of the claims 1 to 11,
**characterized in that**,
the method comprises the following steps:
- coating substrate beads with at least one light emitting layer to form a LED arrangement,
- embedding the coated substrate beads at least partially in at least one a embedding layer
- coating the partially embedded coated substrate beads with a transparent conductive layer deposited on one side of the embedding layer, as a front contact,
- further coating the other side of the embedding layer and the partially embedded coated substrate beads with at least one other conductive layer deposited on the other side of the embedding layer.

13. Method for producing a large area LED-lighting device according to claim 12,
**characterized in that**,
the method further comprises a step of at least partially embedding at least one conductive member in the embedding layer or applying at least one metal strip coating on the embedding layer.

14. Method for producing a large area LED-lighting device according to one of the claims 12 or 13,
**characterized in that**,
the method further comprises a step of cutting through the front and/or back contact to get at least two distinct zones.

15. Method for producing a large area LED-lighting device according to one or more of the claims 12 to 14,
**characterized in that,**
the method further comprises a step of adding an additional protective layer or a metal layer on one or of both sides of embedding layer.
